**Europäisches Patentamt**

**European Patent Office**

**Office européen des brevets**

(11) Numéro de publication: **0 225 218 B1**

## (12) FASCICULE DE BREVET EUROPEEN

(45) Date de publication du fascicule du brevet:
**16.05.90**

(21) Numéro de dépôt: **86402345.2**

(22) Date de dépôt: **20.10.86**

(51) Int. Cl.⁵: **H03B 19/00, H04L 27/12**

(54) **Procédé de synthèse de fréquence, et appareil synthétiseur utilisant ce procédé.**

(30) Priorité: **22.10.85 FR 8515662**

(43) Date de publication de la demande:
**10.06.87 Bulletin 87/24**

(45) Mention de la délivrance du brevet:
**16.05.90 Bulletin 90/20**

(84) Etats contractants désignés:
**DE IT NL SE**

(56) Documents cités:
**CH-A- 331 077**
**NL-A- 7 204 807**

(73) Titulaire: **THOMSON-CSF, 51, Esplanade du Général de Gaulle, F-92800 Puteaux(FR)**

(72) Inventeur: **Kantorowicz, Gérard, THOMSON-CSF SCPI 19, avenue de Messine, F-75008 Paris(FR)**

(74) Mandataire: **Trocellier, Roger et al, THOMSON-CSF SCPI, F-92045 PARIS LA DEFENSE CEDEX 67(FR)**

**Description**

La présente invention concerne un procédé de synthèse de fréquence ainsi que les appareils utilisant ce procédé.

Certains systèmes de transmission, en particulier ceux conçus pour résister au brouillage, exigent des sauts de fréquence très rapides de la porteuse, avec une phase connue permettant d'effectuer à la réception une démodulation cohérente.

Les synthétiseurs de fréquence sont des générateurs capables d'assurer la sélection à la demande d'une raie de fréquence déterminée parmi une pluralité de raies disponibles.

La fréquence de sortie est généralement obtenue par asservissement d'un oscillateur par une boucle de phase sur une fréquence de référence. La commutation de fréquence dans les synthétiseurs pour fréquences supérieures à quelques MHz les plus rapides connus, du type à boucle de phase, demande un minimum de temps de plusieurs microsecondes fonction, en particulier, de la bande passante de la boucle de phase.

Les raies de fréquence résultent généralement de mélanges, multiplications et divisions de plusieurs fréquences de référence, et ces opérations, en particulier la division de fréquence numérique, ne permettent pas d'assurer la continuité de la phase de la nouvelle fréquence par rapport à l'ancienne.

Selon encore une autre technique, on produit un peigne de fréquence, puis une sélection de la raie désirée est obtenue par commutation des sorties d'un banc de filtres de fréquence. Ces filtres à base d'ondes de surface acoustique ont un retard de propagation non négligeable, de l'ordre de une à trois microsecondes, et l'équilibrage du temps de retard, donc du déphasage, constitue la limite de ce type de synthétiseur.

Le but de l'invention est de remédier aux insuffisances et limitations des techniques précitées en concevant un synthétiseur permettant de répondre à des exigences de commutation très rapide et de continuité de la phase du signal.

Il est connu entre autres par le document "Digital Communications by Satellite" de V.K. BHARGAVA et al page 69, J. WILEY, New York, 1981, un modulateur binaire d'une fréquence porteuse comportant deux voies en phase et quadrature pour réaliser un saut de fréquence avec continuité de la phase (technique dénommée CPFSK dans la littérature anglo-saxonne, abrégé de Continuous Phase Frequency Shift Keying). Les deux états binaires sont ainsi traduits par deux fréquences. Les moyens utilisés consistent en une première paire de mélangeurs pour constituer des signaux respectivement en quadrature sur chaque voie avec un signe désiré et relatifs à une fréquence de saut $F_r$, et une deuxième paire de mélangeurs pour multiplier ces signaux de saut avec des signaux en quadrature correspondant à une fréquence de porteuse $F_c$, les sorties étant ensuite additionnées pour obtenir le signal final correspondant à la fréquence $F_c+F_r$, ou à la fréquence $F_c-F_r$, selon l'état binaire 0 ou 1 que l'on veut transmettre. La continuité de la phase est assurée dès lors que le changement de signe des signaux de saut s'effectue aux instants où la phase du signal de sortie vaut "0" ou " $\pi$ ". Ce résultat est obtenu selon des techniques connues, en produisant par exemple les signaux à la fréquence de saut $F_r$ et à celles de porteuse $F_c$ à partir d'une horloge commune qui synchronise également les autres signaux de commande et ceux utilisés pour les changements de signes.

Un objet de l'invention est de reprendre cette technique de base et de la modifier et l'adapter pour obtenir un synthétiseur de fréquence répondant aux exigences techniques déjà mentionnées.

Selon l'invention, ce but est atteint en procédant selon les caractéristiques techniques figurant dans la revendication 1 ainsi que dans l'appareil selon la revendication 4.

Les particularités et avantages de l'invention apparaîtront dans la description qui suit donnée à titre d'exemple à l'aide des figures annexées qui représentent :

- Figure 1, un schéma général de principe d'un synthétiseur conforme à l'invention ;
- Figure 2, un diagramme général d'un synthétiseur selon l'invention ;
- Figure 3, un schéma du module ou cellule de base utilisé pour produire les signaux en quadrature relatifs à la fréquence de saut ;
- Figures 4A à G, divers cas de fonctionnement possibles d'un ensemble de deux cellules conforme au schéma figure 3 ;
- Figure 5, un diagramme des fréquences porteuses obtenues avec le montage de la figure 4 ;
- Figure 6, un diagramme d'un exemple de réalisation d'un appareil synthétiseur conforme à l'invention ;
- Figure 7, un schéma de détail relatif à un arrangement possible des circuits annexes générateurs des signaux de saut et de porteuse et des signaux de commutation et de signe ;
- Figures 8A et 8B, deux cas supplémentaires de fonctionnement d'un ensemble de deux cellules ;
- et Figure 9, un diagramme d'une variante de réalisation de l'appareil synthétiseur selon la figure 6 pour produire des cas complémentaires de fonctionnement, du type représenté sur les figures 8A et 8B.

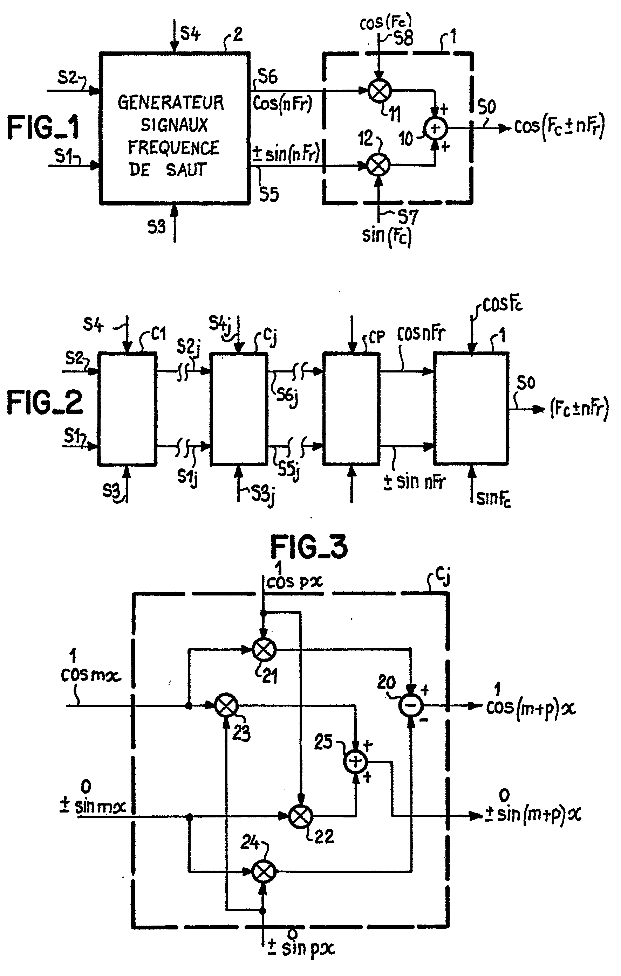

En référence à la figure 1, un générateur de sauts de fréquence conforme à l'invention présente un circuit terminal 1 avec deux éléments de multiplication 11 et 12 et un circuit sommateur 10. Les éléments de multiplication peuvent être constitués par exemple de mélangeurs équilibrés, mais cette forme de réalisation n'est pas limitative. Ces éléments sont dans la suite désignés par le terme mélangeur. Les signaux appliqués aux mélangeurs comportent deux signaux en quadrature de phase d'une même fréquence porteuse. A titre de simplification, on a indiqué par sin $F_c$ le signal correspondant au sinus de cette fréquence porteuse (sin $2\pi F_c t$) et cos $F_c$ le

signal correspondant au cosinus de cette fréquence porteuse (cos $2\pi$ $F_c$t), étant entendu également que les amplitudes de ces ondes sinusoïdales sont considérées avoir la valeur unité. Il est entendu également que les deux mélangeurs 11 et 12 sont des mélangeurs équilibrés c'est-à-dire que chacun ne fournit pas de signal autre que le produit des deux signaux appliqués et qu'ils sont parfaitement identiques en amplitude et en phase. Les deux signaux de porteuse sont multipliés respectivement avec deux signaux S5, S6 également en quadrature et relatifs à une fréquence de saut à effectuer. Les sorties des mélangeurs sont additionnées dans le circuit sommateur 10 pour fournir le signal de sortie dont la fréquence est égale à la fréquence centrale $F_c$ augmentée de la valeur de saut avec le signe positif ou négatif selon le signe présenté par les signaux de fréquence de saut.

Dans le cas simple de la technique connue du modulateur binaire indiqué précédemment, les signaux de saut en quadrature sont obtenus par un circuit générateur 2 simplement constitué par une deuxième paire de mélangeurs équilibrés recevant sur un premier mélangeur les signaux S1 et S3 indiqués et sur un deuxième mélangeur les signaux S2 et S4 indiqués. Les signaux S1 et S2 sont des signaux de signe, ils ont pour valeur ± 1 selon le signe positif ou négatif que l'on veut affecter aux valeurs S3 et S4 correspondantes.

Les signaux S3 et S4 correspondent respectivement au cosinus d'une fréquence de saut $F_r$ et au sinus de la même fréquence de saut $F_r$. Les sorties S5 et S6 correspondantes sont multipliées par les signaux de fréquence porteuse dans les mélangeurs 11 et 12. On produit finalement ainsi deux valeurs de fréquence de sortie $F_c$ ± $F_r$ soit un saut de valeur 2$F_r$ permettant l'utilisation envisagée en tant que modulateur binaire.

Selon l'invention, le générateur de signaux de sauts en quadrature 2 est organisé différemment, composé d'une pluralité de cellules C1 à CP avec des entrées telles que S1, S2, S3 et S4, mais avec des signaux différents de manière à produire en sortie une fréquence de saut égale ou multiple d'une fréquence de base $F_r$ indiquée sous la forme n$F_r$, "n" pouvant avoir la valeur "1" ou une valeur supérieure dans le cas d'un harmonique. De même que précédemment on a indiqué ces signaux par sin n $F_r$ et cos n $F_r$ à titre de simplification. La valeur correspondante au sinus est affecté du signe ± 1 compte tenu du signe ± que l'on veut affecter au saut de fréquence n$F_r$ en sortie (la valeur correspondant au cosinus n'est pas affectée d'un signe étant donné qu'il s'agit d'une fonction paire).

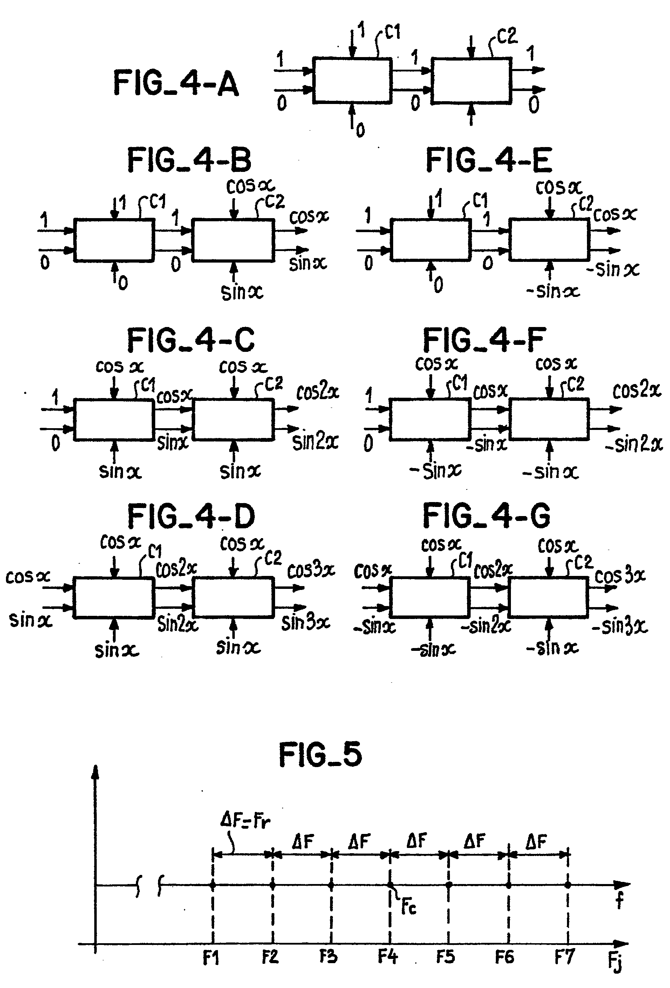

En se reportant à la figure 2 on distingue plus en détail l'organisation du générateur de signaux de fréquence de saut sous forme d'une pluralité de cellules C1 à CP. Chacune de ces cellules comporte comme il est détaillé sur la figure 3 suivante, pour l'une quelconque Cj d'entre elles , deux paires de mélangeurs équilibrés, 21 et 22 d'une part, 23 et 24 d'autre part, et deux sommateurs 20 et 25 montés l'un en soustracteur et l'autre en additionneur. Chaque cellule comporte deux paires d'entrées, une première paire S1j et S2j et une deuxième paire S3j et S4j. Les deux entrées S1j et S2j correspondent à la réception d'une première paire de signaux de saut en quadrature désignés par ± sin m x et cos m x (avec x = $2\pi$ $F_r$t) ; ces signaux représentent donc généralement l'un des harmoniques de la fréquence $F_r$, celui de rang "m" lorsque ce paramètre qui est un nombre entier présente une valeur supérieure à 1 ; le cas m = 1 est également prévu et les signaux correspondent alors à la fréquence de base $F_r$. Les signaux S3j et S4j correspondent à une deuxième paire de signaux de saut en quadrature de phase que l'on désigne par + sin p x et cos p x respectivement en considérant également que le paramètre "p" est égal ou supérieur à 1. Dans les exemples de fonctionnement décrits ultérieurement il s'avère que "m" est égal ou supérieur à "p" mais ceci n'est pas une obligation. Le traitement par multiplication et sommation des signaux S1j et S3j qui correspondent à des sinus et des signaux S2j et S4j qui correspondent à des cosinus fournit en sortie une paire de signaux S5j et S6j qui sont des signaux de saut en quadrature de phase mais dont la fréquence est cette fois égale à l'harmonique de rang "m± p" (le signe négatif est obtenu pour les valeurs négatives de S1j et S3j, -sin mx et - sin px) de la fréquence de base $F_r$. Cette opération est reprise si nécessaire, dans une cellule suivante, et ainsi de suite jusqu'à ce que l'on obtienne à l'entrée du circuit terminal 1 la paire de signaux de saut avec la valeur de fréquence n $F_r$ souhaitée pour le saut de fréquence.

La fonction assurée par la cellule de base correspond à l'application des deux relations trigonométriques :

cos mx cos px - sin mx sin px = cos (m+p) x
± (cos mx sin px ± sin mx cos px) = ± sin (m+p) x.

Toutes les voies doivent être parfaitement équilibrées. Les imperfections d'équilibrage risquent de faire apparaître des mélanges parasites dont le niveau peut être estimé à -40dB sous le signal utile avec des mélangeurs et additionneurs possédant des bonnes performances. Des raies parasites de niveau plus faible peuvent être obtenues au prix de réglages plus longs et plus coûteux, ou bien par une réalisation sous la forme d'un circuit intégré.

Le synthétiseur est obtenu par la mise en cascade de plusieurs cellules de base Cj, comme indiqué sur la figure 2. Les entrées S1 et S2 constituent les sorties de la cellule précédente C$_{j-1}$ et les sorties S5 et S6 constituent les entrées de la cellule suivante C$_{j+1}$.

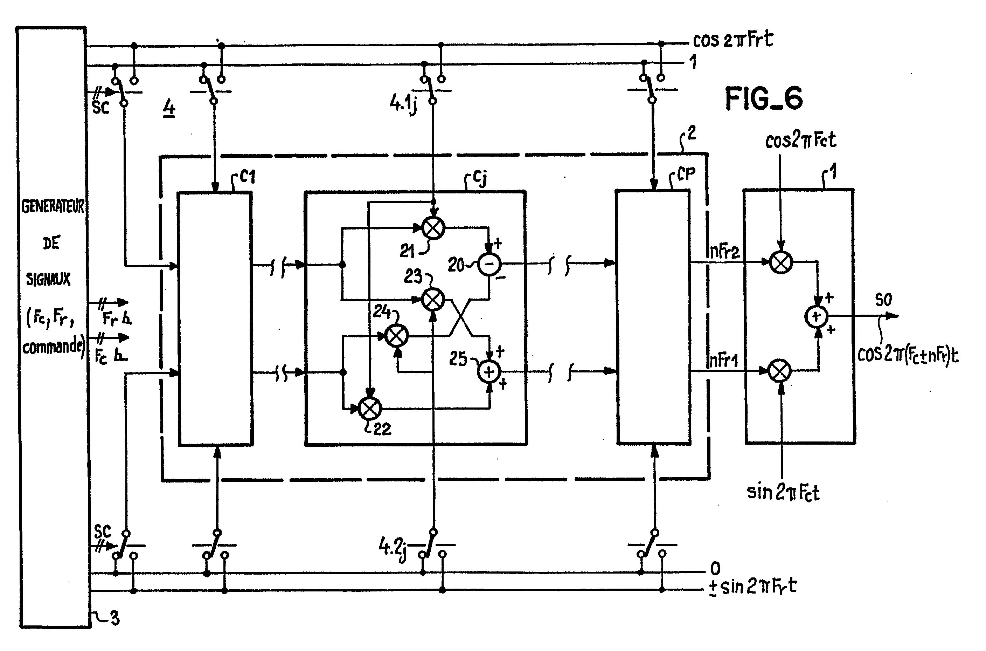

Selon un mode simple de réalisation schématisé sur la figure 6, des circuits annexes 3 produisent les signaux de base qui sont les deux signaux de porteuse cos $F_c$ et sin $F_c$, les deux signaux de fréquence de saut de base cos $F_r$ et sin $F_r$ ainsi que deux autres signaux qui correspondent aux valeurs "1" et "0". Les signaux cos $F_c$ et sin $F_c$ sont appliqués dans le circuit terminal 1 aux mélangeur 11 et 12 respectivement. Les signaux correspondant à cos $F_r$ et à la valeur "1" peuvent être commutés et appliqués aux entrées S2j et S4j des différentes cellules. Les deux autres valeurs correspondant à sin $F_r$ et à la

valeur "0" sont destinés eux aux entrées S1j et S3j des cellules.

La figure 4 montre le fonctionnement avec deux cellules C1 et C2 permettant d'obtenir sept combinaisons différentes auxquelles correspondent sept fréquences équidistantes à partir d'une seule fréquence de base $F_r$ pour les sauts.

La figure 5 montre la répartition de ces sept fréquences F1 à F7, la fréquence F4 correspondant à la fréquence de porteuse $F_c$ et l'écart de fréquence d'une valeur à la suivante étant égal à $F_r$. La figure 4a correspond à l'obtention de la fréquence $F_c$, les figures 4b et 4e à l'obtention de fréquences $F_c \pm F_r$, les figures 4c et 4f à l'obtention de $F_c \pm 2F_r$ et enfin les figures 4d et 4g à l'obtention de $F_c \pm 3F_r$. On peut remarquer, en considérant ces figures, qu'à l'aide d'une seule cellule on obtient cinq valeurs différentes, celles correspondant aux sorties des figures 4a,4b,4c,4e,4f ; l'adjonction d'une deuxième cellule C2 permet d'obtenir en outre les deux configurations supplémentaires de signaux de sortie des figures 4d et 4g. De manière générale, avec les valeurs simples $\pm \sin x$ et $\cos x$ envisagées pour les signaux d'entrée S3j et S4j on obtient pour n cellules, 3+2n combinaisons différentes et autant de valeurs de fréquence différentes en sortie. Il va de soi que si on conçoit le dispositif avec des valeurs harmoniques du genre $\pm \sin px$ et $\cos px$ envisagées sur la figure 3 sur les entrées latérales S3j et S4j on peut accroître encore le nombre de combinaisons mais ceci peut conduire a priori à une exécution plus complexe de l'appareil.

La figure 6 montre un agencement simple de l'ensemble avec un circuit annexe 3 générateur de signaux comportant les fréquences $F_r$ et $F_c$ ainsi que les signaux "0" et "1" et des signaux de commande d'un ensemble de circuits commutateurs pour faire basculer les signaux d'entrée des cellules entre deux valeurs.

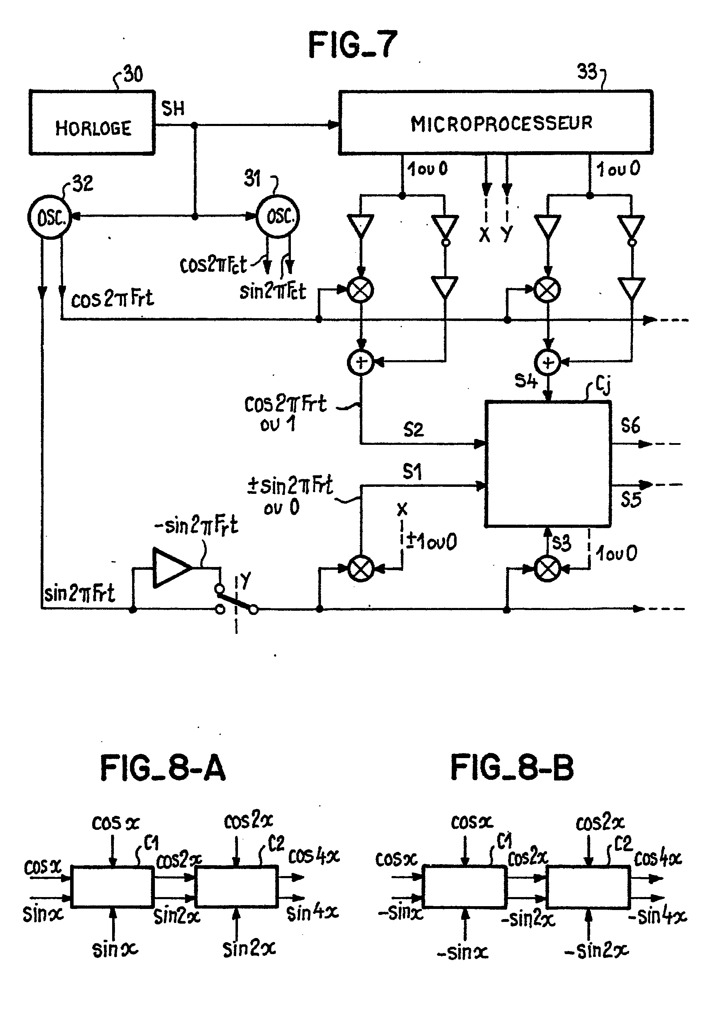

La figure 7 indique à titre d'exemple non limitatif un mode de réalisation possible des circuits annexes 3 et des commutations. Les circuits générateurs de signaux 3 comportent une base de temps 30 qui synchronise par un signal d'horloge SH deux oscillateurs commandés, un oscillateur 31 qui délivre les signaux en quadrature correspondant à la fréquence porteuse, et un deuxième oscillateur 32 qui délivre les signaux en quadrature correspondant à la fréquence de base $F_r$ de saut. Cette horloge est d'autre part reliée à un bloc générateur de signaux de commande de commutation qui peut être commodément réalisé à l'aide d'un microprocesseur 33 lequel délivre à des circuits logiques de commutation des signaux "1" ou "0" pour obtenir aux entrées S1,S2,S3 et S4 des cellules les signaux désirés. Les commandes de commutation "1" et "0" sont élaborées aux instants correspondant aux valeurs de phase 0 et $\pi$ des signaux.

La fréquence du signal d'horloge SH est multiple des deux autres valeurs $F_r$ et $F_c$.

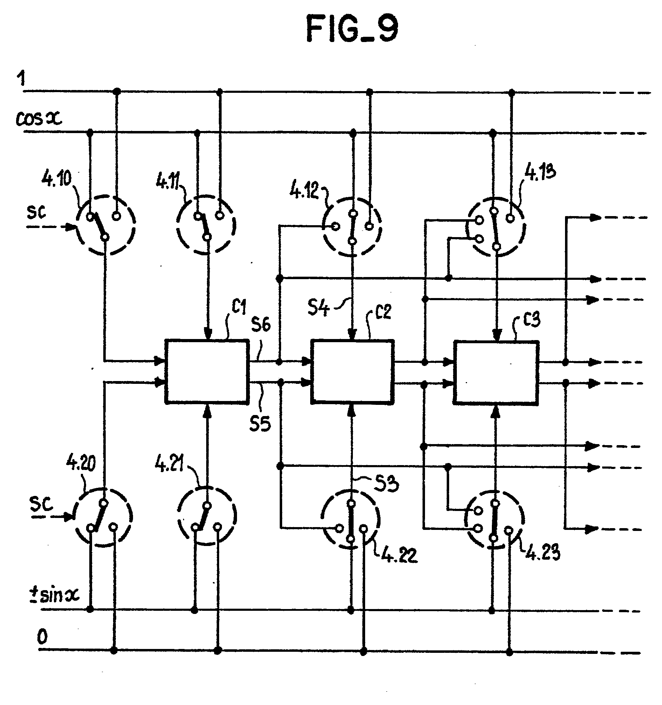

Les figures 8A et 8B montrent deux autres montages à deux cellules suivants lesquels des fréquences supplémentaires sont obtenues en prenant pour les entrées latérales des signaux harmoniques de la fréquence de base $F_r$. Ces solutions sont possibles notamment en produisant des commutations supplémentaires en connectant la sortie d'une cellule de base simultanément à deux entrées de la cellule suivante comme représenté sur la figure 9.

Ainsi, les sorties S5 et S6 de la cellule C1 par exemple sont appliquées en outre par le biais d'une troisième position de commutation aux entrées S3 et S4 respectivement de la cellule 2 suivante ce qui permet, selon les figures 8A et 8B précédentes de former l'harmonique de rang 4 avec ces deux cellules. En ce qui concerne les cellules suivantes on peut répéter l'opération en incluant également la sortie précédente comme position de commutation des entrées latérales, c'est-à-dire que la cellule C3 va avoir encore une position supplémentaire soit quatre au total permettant d'accroître le nombre de possibilités de sauts en sortie, tout en diminuant le nombre de cellules de base constituant l'appareil synthétiseur.

**Revendications**

1. Procédé de synthèse de fréquence qui consiste à multiplier deux signaux en quadrature relatifs à une fréquence porteuse $F_c$ respectivement par deux signaux en quadrature relatifs à une fréquence de saut $F_r$ et à additionner les résultats de ces deux multiplications pour obtenir un signal de fréquence $F_c$ augmentée de la valeur de saut $F_r$ avec un signe positif ou négatif selon celui affectant les signaux en quadrature relatifs à cette fréquence de saut, caractérisé en ce que lesdits signaux de fréquence de saut correspondent à une fréquence de base $F_r$ multipliée par un coefficient "n" auquel on peut attribuer sur commande n'importe quelle valeur entière désirée pour l'exploitation est comprise entre la valeur minimale 1 et une valeur maximale N prédéterminée, la fréquence de saut correspondant ainsi à ladite fréquence de base, ou bien à l'harmonique de rang n, ladite fréquence de saut étant fournie en effectuant au moins un ensemble d'opérations de multiplication et de sommation, chaque ensemble d'opérations constituant à multiplier une première paire de signaux de saut en quadrature (S1j et S2j) de fréquence m $F_r$ (m entier égal ou supérieur à 1) avec une deuxième paire de signaux de saut en quadrature (S3j et S4j) de fréquence p $F_r$ (p entier égal ou supérieur à 1) et à sommer les résultats de ces multiplications avec le signe donné pour fournir une troisième paire de signaux de saut en quadrature (S5j et S6j) de fréquence (m+p)Fr, cet ensemble d'opérations de multiplication et de sommation étant renouvelé si nécessaire en remplaçant le coefficient "m" par celui "m+p" lui vient d'être obtenu et en modifiant éventuellement le coefficient "p" en sorte d'aboutir à la valeur de fréquence $\pm$ n Fr désirée pour les signaux de saut à multiplier avec lesdits signaux de fréquence porteuse ($\sin F_c$ et $\cos F_c$).

2. Procédé selon la revendication 1, caractérisé en ce que chaque ensemble d'opérations de multiplication et d'addition consiste à effectuer les produits $\cos mx.\cos px$ et $\sin mx.\sin px$, leur différence donnant cos(m+p)x, et les produits ± (cos mx sin px) et ± (sin mx.cos px), leur somme donnant ± sin (m+p)x (avec x = 2 $F_r$t) et qu'il est prévu également la possibilité de remplacer dans ledit ensemble d'opérations l'une ou l'autre desdites valeurs de cosinus, ou les deux, par la valeur "1", et l'une ou l'autre desdites valeurs de sinus, ou les deux, par la valeur 0, selon la valeur "m+p" désirée pour le résultat de l'ensemble d'opérations considéré.

3. Procédé selon la revendication 2, caractérisé en ce qu'il permet d'obtenir les différentes valeurs de sauts de fréquence dans la plage 1 à N considérée à partir d'un nombre réduits de signaux simples comportant, lesdites valeurs "0" et "1", une paire de signaux (cos $F_r$ et ± sin $F_r$) en quadrature correspondant à ladite fréquence de base $F_r$ et une paire de signaux en quadrature (cos $F_c$ et sin $F_c$) correspondant à ladite fréquence porteuse $F_c$.

4. Appareil synthétiseur de fréquence comportant un circuit générateur (2) de deux signaux (S5, S6) en quadrature relatifs à une fréquence de saut ($F_r$), et un circuit terminal (1) ayant deux mélangeurs équilibrés (11, 12) pour multiplier lesdits signaux de saut respectivement avec deux signaux en quatrature (S7, S8) relatifs à une fréquence porteuse ($F_c$) et un sommateur (10) pour additionner les sorties des mélangeurs et fournir un signal (S0) transposé en fréquence de la valeur des sauts ($F_c$ ± $F_r$) avec un signe positif ou négatif selon celui présenté par lesdits signaux de saut, l'appareil étant caractérisé en ce que le circuit générateur (2) délivre lesdits signaux de saut avec une fréquence égale à "n" fois une fréquence de base $F_r$ (n entier supérieur ou égal à 1) selon la valeur n $F_r$ de saut désirée pour l'exploitation et qui est choisie dans une plage comprise entre $F_r$ et une valeur maximale N $F_r$ prédéterminée, ledit circuit générateur étant composé d'une pluralité P de circuits élémentaires dits cellules (C1 à CP) connectés en cascade, chacune (Cj) des cellules comportant une première paire de mélangeurs équilibrés (21, 22) connectés par leur sortie à un circuit sommateur (20) monté en soustracteur, une deuxième paire de mélangeurs équilibrés (23, 22) connectés par leur sortie à un circuit sommateur (25) monté en additionneur, une première paire d'entrée (S1j, S2j) pour recevoir deux signaux de sauts en quadrature de fréquence m $F_r$ ("m" entier égal ou supérieur à 1), une deuxième paire d'entrée (S3j, S4j) pour recevoir deux signaux de saut en quadrature de fréquence p $F_r$ ("p" entier égal ou supérieur à 1), et deux sorties (S5j, S6j) pour délivrer à la suite des multiplications et sommations deux signaux de sauts en quadrature de fréquence (m+p) $F_r$ avec le signe désiré, lesdites sorties étant connectées à la première paire d'entrée de la cellule suivant (Sj+1) et ainsi de suite, les valeurs "m", "p" des harmoniques de la fréquence de base $F_r$ étant choisies pour chaque cellule de manière à obtenir en sortie des P cellules la valeur d'harmonique de rang "n" désirée pour le saut de fréquence.

5. Appareil selon la revendication 4, caractérisé en ce qu'il comporte des circuits annexes (3) pour produire les signaux en quadrature relatifs à la fréquence porteuse $F_c$ et à la fréquence de base de saut $F_r$ avec l'information de signe à partir d'une horloge (30, SH) commune, des signaux ayant pour valeur "1" et "0", et des signaux de commande (SC), de commutation, et des circuits de commutation (4) pour commuter sur lesdites deuxièmes paires d'entrée (S3j, S4j) et sur la première paire d'entrée (S1, S2) de la première cellule, soit le couple de signaux "0" et "1", soit le couple de signaux en quadrature de fréquence $F_r$, lesdits circuits annexes comprenant un processeur ou une logique cablée (33) pour commander lesdites commutations en fonction de la valeur "± n" de saut sélectionnée pour l'exploitation.

6. Appareil selon la revendication 5, caractérisé en ce qu'au moins l'une des cellules de rang 2 ou plus comportent des circuits de commutation associés (4.12, 4.22) ayant au moins une position de commutation supplémentaire connectée à la sortie correspondante (S6, S5) de la cellule précédente.

7. Appareil selon la revendication 6, caractérisé en ce que lesdites positions de commutation supplémentaires englobent pour une cellule (Cj) de rang (j étant supérieur ou égal à 2), (j-1) positions supplémentaires raccordées respectivement aux sorties des cellules de rang 1 à (j-1) précédentes.

## Claims

1. A method of frequency synthesis which consists of multiplying two signals which are in quadrature relative to a carrier frequency $F_c$ respectively by two signals which are in quadrature in relation to a jump frequency $F_r$ and of adding the results of these two multiplying operations in order to obtain a signal of the frequency $F_c$ incremented by the jump value $F_r$ with a positive or negative prefix sign in accordance with that belonging to the quadrature signals relative to this jump frequency, characterized in that the said jump frequency signals correspond to a base frequency $F_r$ multiplied by a coefficient "n" to which there may be attributed by control any integral value desired for operation and comprised between the minimum value of 1 and a predetermined value of N, the jump frequency thus corresponding to the said base frequency or indeed to the n-order harmonic, the said jump frequency being supplied by performing at least one set of operations of multiplication and summation, each set of operations comprising the multiplication of a first pair of jump quadrature signals (S1 and S2j) of a frequency m $F_r$ (with m being an integral equal to or greater than 1) by a second pair of quadrature jump signals (S3j and S4j) with a frequency of p $F_r$ (with p being an integral equal to or greater than 1) and summating the results of such multiplication operations with the given prefix sign in order to provide a third pair of quadrature jump signals (S5j and S6j) with a frequency of (m+p)Fr, said set of operations of multiplication and summation being repeated if necessary replacing the "m" coefficient by the "m+p" coefficient which has just been produced and possibly modifying the "p" coefficient in such a manner as to arrive at the ±n Fr frequency desired for the jump signals to be multiplied by the said carrier frequency signals (sin $F_c$ and cos $F_c$).

2. The method as claimed in claim 1, characterized in that each set of operations of multiplication and addition consists in producing the products cos mx.cos px and sin mx.sin ps, their difference yielding cos(m+p)x, and the products ± (cos mx sin px) and ± (sin mx cos px), their sum yielding ± sin(m+p)x (with x equal to 2 $F_r$t) and with the further possibility of replacing, in the said set of operations one or the other of the said cosine values, or both of them, by the value of "1", one or the other of the said sine values, or both of them, by the value of 0 in accordance with the value of "m+p" desired for the result of the set of operations considered.

3. The method as claimed in claim 2, characterized in that it makes possible the production of the different frequency jump values in the range 1 through N considered as from a reduced number of simple signals comprising, the said values "0" and "1", a pair of quadrature signals (cos $F_r$ and ± sin $F_r$) corresponding to the said base $F_r$ frequency and a pair of quadrature signals (cos $F_c$ and sin $F_c$) corresponding to the said carrier frequency $F_c$.

4. A frequency synthesizing apparatus comprising a generating circuit (2) for producing two signals (S5 and S6) in quadrature in relation to a jump frequency (Fr), and a terminal circuit (1) having two balanced mixers (11 and 12) in order to multiply the said jump signals respectively by two signals (S7 and S8) in quadrature relative to a carrier frequency (Fc) and a summating device (10) in order to add the outputs of the mixers and to supply a signal (S0) transposed to the frequency of the value of the jumps ($F_c$ ± $F_r$) with a positive or negative sign in accordance with the sign of the said jump signals, said apparatus being characterized in that the said generating circuit (2) supplies the said jump signals with a frequency equal to "n" times a base $F_r$ frequency (n being integral and greater than or equal to 1) in accordance with the jump value n $F_r$ desired for operation and which is selected in a range comprised between $F_r$ and a predetermined maximum value N $F_r$, the said generating circuit being made up of a plurality P of elementary circuits or cells (C1 through CP) connected in cascade, each (Cj) of the cells comprising a first pair of balanced mixers (21 and 22) connected via their output with a summating circuit (20) connected to operate as a subtracter, a second pair of balanced mixers (23 and 22) connected via their output with a summating circuit (25) connected to operate as an adder, a first input pair (S1j and S2j) in order to receive the quadrature jump signals of a frequency m $F_r$ (with "m" being integral and equal to or greater than 1), a second input pair (S3j and S4j) in order to receive two quadrature jump signals with a frequency p $F_r$ (with "p" being an integral equal to or greater than 1), and two outputs (S5j and S6j) in order to supply, following multiplication and summating operations, two quadrature jump signals with a frequency of (m+p) $F_r$ with the desired sign, the said outputs being connected with the first input pair of the follwing cell (S+1) and so on, the "m" and "p" value of the harmonics of the base frequency $F_r$ being selected for each cell in such a manner as to obtain at the output of the P cells the harmonic value of the "n" order desired for the frequency jump.

5. The apparatus as claimed in claim 4, characterized in that it comprises adjoined circuits (3) in order to produce quadrature signals relative to the carrier frequency $F_c$ with the sign information starting from a common clock (30 and SH), the signals having "1" and "0" as values, and one of the control signals (SC), for switching, and switching circuits (4) in order to switch to the said input second pairs (S3j and S4j) and to the first input pair (S1 and S2) of the first cell, either the pair of "0" and "1" signals, or the pair of frequency $F_r$ quadrature signals, the said adjoined circuits comprising a processor or wired logic (33) in order to control the said switching as a function of the "± n" jump value selected for operation.

6. The apparatus as claimed in claim 5, characterized in that at least one of the cells of the order 2 or more comprise associated switching circuits (4.12 and 4.22) having at least one supplementary switching position connected with the corresponding output (S6 and S5) of the preceding cell.

7. The apparatus as claimed in claim 6, characterized in that for one cell (Cj) of the order (j being greater than or equal to 2), the said supplementary switching positions comprise (j-1) supplementary positions respectively connected with the preceding outputs of the cells of the order 1 to (j-1).

**Patentansprüche**

1. Verfahren zur Frequenzsynthese, das darin besteht, zwei Quadratur-Signale, die zu einer Trägerfrequenz $F_c$ gehören, jeweils mit einem von zwei Quadratur-Signalen, die zu einer Sprungfrequenz $F_r$ gehören, zu multiplizieren sowie die Ergebnisse dieser beiden Multiplikationen zu summieren, um ein Signal der Frequenz $F_c$, die um den Sprungwert $F_r$ erhöht wird, zu erhalten, mit einem positiven oder einem negativen Vorzeichen, je nach demjenigen, welches die zu dieser Sprungfrequenz gehörenden Quadratur-Signale aufweisen, dadurch gekennzeichnet, daß die genannten Sprungfrequenz-Signale einer Basisfrequenz $F_r$, die mit einem Koeffizient "n" multipliziert ist, entsprechen, welchem man jeden beliebigen erwünschten ganzen Wert für die Anwendung auf Befehl zuweisen kann, die zwischen dem Minimumwert 1 und einem vorbestimmten Maximalwert N enthalten ist, wobei die Sprungfrequenz so der genannten Basisfrequenz oder der Harmonischen der Ordnung n entspricht, wobei die genannte Sprungfrequenz dadurch erzeugt wird, daß wenigstens eine Menge von Multiplikations- und Summieroperationen ausgeführt wird, wobei jede Menge von Operationen darin besteht, ein erstes Paar von Quadratur-Sprungsignalen (S1j und S2j) der Frequenz m $F_r$ (mit m ganzzahlig gleich oder größer als 1) mit einem zweiten Paar von Quadratur-Sprungsignalen (S3j und S4j) der Frequenz p $F_r$ (mit p ganzzahlig gleich oder größer als 1) zu multiplizieren und die Ergebnisse dieser Multiplikationen mit dem gegebenen Vorzeichen zu summieren, um ein drittes Paar von Quadratur-Sprungsignalen (S5j und S6j) der Frequenz $(m+p)F_r$ zu liefern, wobei diese Menge von Multiplikations- und Summieroperationen, wenn nötig, wiederholt wird, indem der Koeffizient "m" durch den gerade erhaltenen Koeffizient "m+p+ ersetzt wird und indem der Koeffizient "p" eventuell verändert wird, so daß der erwünschte Wert der Frequenz $\pm$ n $F_r$ für die Sprungsignale, die mit den genannten Signalen der Trägerfrequenz (sin $F_c$ und cos $F_c$) multipliziert werden müssen, erhalten wird.

2. Verfahren nach Anspruch 1, dadurch gekennzeichnet, daß jede Menge der Multiplikations- und Addieroperationen darin besteht, die Produkte cos mx.cos px und sin mx.sin px, deren Differenz cos(m+p)x ergibt, und die Produkte $\pm$ (cos mx sin px) und $\pm$ (sin mx.cos px), deren Summe $\pm$ sin (m+p)x (mit x = 2 $F_r$t) ergibt, zu berechnen, und daß auch die Möglichkeit vorgesehen ist, in der genannten Menge von Operationen den einen oder den anderen Wert der genannten Kosinuswerte oder die beiden Werte durch den Wert "1" sowie den einen oder den anderen Wert der genannten Sinuswerte, oder beide, durch den Wert 0 zu ersetzen, je nach dem Wert "m+p", der für das Ergebnis der betrachteten Menge der Operationen erwünscht ist.

3. Verfahren nach Anspruch 2, dadurch gekennzeichnet, daß es die Gewinnung der verschiedenen Werte der Frequenzsprünge in dem betrachteten Bereich 1 bis N ausgehend von einer verringerten Anzahl von einfachen Signalen ermöglicht, die die genannten Werte "0" und "1", ein Paar von Quadratur-Signalen (cos $F_r$ und $\pm$ sin $F_r$) der genannten Basisfrequenz $F_r$ und ein Paar von Quadratur-Signalen (cos $F_c$ und sin $F_c$), die der genannten Trägerfrequenz $F_c$ entsprechen, umfassen.

4. Frequenz-Synthesegerät, das eine Generatorschaltung (2) zum Erzeugen zweier Quadratur-Signale (S5, S6), die zu einer Sprungfrequenz ($F_r$) gehören, sowie eine Endschaltung (1) umfaßt, die zwei abgeglichene Mischer (11, 12) aufweist, um die genannten Sprungsignale jeweils mit einem von zwei Quadratur-Signalen (S7, S8) zu multiplizieren, die zu einer Trägerfrequenz ($F_c$) gehören, sowie eine Summiereinrichtung (10) umfaßt, um die Ausgangssignale der Mischer zu addieren sowie ein Signal (S0) abzugeben, das in der Frequenz um den Wert der Sprünge ($F_c \pm F_r$) versetzt wird, mit einem positiven oder einem negativen Vorzeichen, je nach demjenigen, das die genannten Sprungsignale aufweisen, wobei das Gerät dadurch gekennzeichnet ist, daß die Generatorschaltung (2) die genannten Sprungsignale mit einer Frequenz abgibt, die dem "n"-fachen einer Basisfrequenz $F_r$ entspricht (mit n ganzzahlig größer als oder gleich 1), je nach dem Sprungwert n $F_r$, der für die Anwendung erwünscht und in einem Bereich gewählt ist, der zwischen $F_r$ und einem vorbestimmten Maximalwert N $F_r$ enthalten ist, wobei diese Generatorschaltung aus einer Vielzahl P von als Zellen (C1 bis CP) bezeichneten Elementarschaltungen besteht, die in Kaskade geschaltet sind, wobei jede (Cj) der Zellen umfaßt: ein erstes Paar von abgeglichenen Mischern (21, 22), die an ihrem Ausgang mit einer als Subtrahierer geschalteten Summier-Schaltung (20) verbunden sind, sowie ein zweites Paar von abgeglichenen Mischern (23, 22), die an ihrem Ausgang mit einer als Addierer geschalteten Summier-Schaltung (25) verbunden sind, ein erstes Eingangspaar (S1j, S2j), um zwei Quadratur-Sprungsignale der Frequenz m $F_r$ ("m" ganzzahlig gleich oder größer als 1) zu erhalten, ein zweites Eingangspaar (S3j, S4j), um zwei Quadratur-Sprungsignale der Frequenz p $F_r$ ("p" ganzzahlig gleich oder größer als 1) zu erhalten, sowie zwei Ausgänge (S5j, S6j), um nach den Multiplikationen und Summierungen zwei Quadratur-Sprungsignale der Frequenz (m+p) $F_r$ mit dem gewünschten Vorzeichen abzugeben, wobei die genannten Ausgänge mit dem ersten Eingangspaar der folgenden Zelle (Sj+1), und so weiter, verbunden sind, wobei die Werte "m", "p" der Harmonischen der Basisfrequenz $F_r$ für jede Zelle so ausgewählt sind, daß am Ausgang der P Zellen der Wert der Harmonischen der Ordnung "n", der für den Sprung der Frequenz erwünscht ist, erhalten wird.

5. Gerät nach Anspruch 4, dadurch gekennzeichnet, daß es umfaßt: Hilfsschaltungen (3), um die Quadratur-Signale, die zu der Trägerfrequenz $F_c$ und der Basis-Sprungfrequenz $F_r$ gehören, mit der Vorzeichen-Information ausgehend von einem gemeinsamen Taktgeber (30, SH), Signale, die einen Wert "1" und "0" haben, und Umschalt-Steuersignale (SC) zu erzeugen; sowie Umschaltschalter (4), um auf die genannten zweiten Eingangspaare (S3j, S4j) und auf das erste Eingangspaar (S1, S2) der ersten Zelle entweder das Signalpaar "0" und "1" oder das Quadratur-Signalpaar der Frequenz $F_r$ umzuschalten; wobei die genannten Hilfsschaltungen einen Prozessor oder eine verdrahtete Logik (33) umfassen, um die Umschaltungen in Abhängigkeit von dem für die Anwendung ausgewählten Sprungwert "$\pm$ n" zu steuern.

6. Gerät nach Anspruch 5, dadurch gekennzeichnet, daß wenigstens eine der Zellen der Ordnung 2 oder mehr von ihnen zugeordnete Umschaltschalter (4.12, 4.22) umfassen, die wenigstens eine zusätzliche Umschaltposition aufweisen, die mit dem entsprechenden Ausgang (S6, S5) der vorausgehenden Zelle verbunden ist.

7. Gerät nach Anspruch 6, dadurch gekennzeichnet, daß die genannten zusätzlichen Umschaltpositionen für eine Zelle (Cj) der Ordnung (wobei j größer als oder gleich 2 ist) (j-1) zusätzliche Positionen umfassen, die jeweils an die Ausgänge der vorausgehenden Zellen der Ordnung 1 bis (j-1) angeschlossen sind.

FIG_1

FIG_2

FIG_3

FIG_4-A

FIG_4-B

FIG_4-E

FIG_4-C

FIG_4-F

FIG_4-D

FIG_4-G

FIG_5

FIG_6

cos 2πFrt

cos2πFct

sin2πFct

SO

cos2π(Fc±nFr)t

EP 0 225 218 B1

# FIG_7

# FIG_8-A

# FIG_8-B

# FIG_9